# EUROPEAN PATENT APPLICATION

(11) **EP 4 641 753 A2**
(43) Date of publication of application: **29.10.2025**
(21) Application number: 25171427.5
(22) Date of filing: 17.04.2025
(51) Int. Cl.: H01M 10/42, H01M 10/48, H01M 50/284

(54) **BATTERY MANAGEMENT APPARATUS**

(30) Priority: 22.04.2024 KR 20240053115
(71) Applicant: SK On Co., Ltd., Seoul 03161 (KR)
(72) Inventor: LEE, Jae Hee, 34124 Daejeon (KR); KO, Kyung Chul, 34124 Daejeon (KR); SEO, Dong Hwi, 34124 Daejeon (KR); HWANG, Kyu Min, 34124 Daejeon (KR)
(74) Representative: Stolmár & Partner Patentanwälte PartG mbB

(57) **Abstract**

A battery management apparatus includes a cell monitoring unit including a battery monitoring integrated circuit (IC) configured to generate first sensing data of a battery module, and a battery management unit communicatively coupled to the cell monitoring unit and including: a master controller in communication with the battery monitoring **IC;** and an interface IC configured to perform a communication conversion operation for communication between the battery monitoring IC and the master controller. The cell monitoring unit further includes a battery auxiliary management unit disposed in the battery module. The battery monitoring IC is further configured to perform a communication conversion operation to facilitate communication between the battery auxiliary management unit and the interface IC.

## Description

### BACKGROUND

### 1. FIELD

The disclosed technology relates to a battery management apparatus.

### 2. DESCRIPTION OF RELATED ART

Batteries are widely used not only in small-sized electronic devices such as mobile phones and laptops, but also in medium- and large-sized machines such as electric vehicles (EVs). In addition, batteries may be implemented as secondary batteries, meaning that they can be recharged and reused. A battery may include one or more battery modules.

The safety of a battery may impact the safety of electronic devices or machines in which the battery is used, making battery safety essential.

### SUMMARY

The disclosed technology can be implemented in some embodiments to provide a battery management apparatus having improved efficiency and/or stability in collecting sensing data from a battery module.

In an aspect of the disclosed technology, a battery management apparatus may include a cell monitoring unit including a battery monitoring integrated circuit (IC) configured to generate first sensing data of a battery module, and a battery management unit communicatively coupled to the cell monitoring unit and including: a master controller in communication with the battery monitoring IC; and an interface IC configured to perform a communication conversion operation for communication between the battery monitoring IC and the master controller. The cell monitoring unit may further include a battery auxiliary management unit disposed in the battery module. The battery monitoring IC may perform a communication conversion operation to facilitate communication between the battery auxiliary management unit and the interface IC.

For example, the battery auxiliary management unit may be configured to generate second sensing data of the battery module. The battery management unit may receive the second sensing data from the battery auxiliary management unit, perform communication conversion on the second sensing data to generate converted second sensing data by converting a type of the second sensing data, and transmit the converted second sensing data to the interface IC.

For example, the interface IC may receive second sensing data transmitted from the battery management unit, perform communication conversion on the converted second sensing data to generate resulting second sensing data, and transmit the resulting second sensing data to the master controller.

For example, the battery management apparatus may further include an auxiliary interface unit configured to perform a communication conversion operation for communication between the battery management unit and the master controller. The battery management unit may transmit the converted second sensing data to the master controller through the auxiliary interface unit.

For example, the interface IC may receive a single-ended signal from the master controller, convert the single-ended signal into a differential signal, and transmit the differential signal to the battery management unit, and the interface IC may receive a differential signal from the battery management unit, convert the differential signal into a single-ended signal, and transmit the single-ended signal to the master controller.

For example, the battery management apparatus may further include a first insulating communication port configured to enable transmission of signals from both the master controller and the battery management unit, and a second insulating communication port configured to enable transmission of the second sensing data from the battery management unit.

For example, the first sensing data may include at least one of temperature data, voltage data, current data, or voltage data of at least one of a plurality of battery cells of the battery module. The second sensing data may include at least one of pressure sensing data, gas sensing data, or aerosol sensing data of the battery module.

For example, the battery management apparatus may further include a printed circuit board disposed in the battery module. Each of the battery management unit and the battery auxiliary management unit may include a semiconductor integrated circuit electrically connected to the printed circuit board.

In another aspect of the disclosed technology, a battery management apparatus may include a plurality of battery monitoring integrated circuits (ICs) respectively disposed in a plurality of battery modules, each battery module including a plurality of battery cells stacked on each other, a master controller communicatively coupled to the plurality of battery monitoring ICs to communicate with at least one of the plurality of battery management units, an interface IC configured to perform a communication conversion operation for communication between one of the plurality of battery management units and the master controller, and a plurality of battery auxiliary management units respectively disposed in the plurality of battery modules. One of the plurality of battery management units may perform a communication conversion operation to facilitate communication between at least one of the plurality of battery auxiliary management units and the interface IC.

For example, the plurality of battery management units may transmit second sensing data of the plurality of battery auxiliary management units between the plurality of battery management units through a daisy chain method. One of the plurality of battery management units may transmit the second sensing data to the interface IC or the master controller.

For example, the plurality of battery management units may generate converted second sensing data by convert the second sensing data, transmitted using the daisy chain method, through a universal asynchronous receiver/transmitter (UART) protocol or a serial peripheral interface (SPI) protocol, and may transmit the converted second sensing data to the interface IC or the master controller.

For example, one of the plurality of battery management units may receive a control command from the master controller through the interface IC, and the plurality of battery management units may transmit the control command to each other using the daisy chain method.

For example, the plurality of battery management units may transmit first sensing data to each other using the daisy chain method. One of the plurality of battery management units may transmit first sensing data of the plurality of battery management units to the interface IC or the master controller.

For example, the interface IC may receive a single-ended signal from the master controller, convert the single-ended signal into a differential signal, and transmit the differential signal to one of the plurality of battery management units, and the interface IC may receive a differential signal from one of the plurality of battery management units, convert the differential signal into a single-ended signal, and transmit the single-ended signal to the master controller.

For example, each of the plurality of battery management units may include a semiconductor integrated circuit. Each of the plurality of battery auxiliary management units may include a semiconductor integrated circuit.

In another aspect of the disclosed technology, a battery management apparatus may include a battery module including a plurality of battery cells stacked on each other, a battery monitoring integrated circuit (IC) communicatively coupled to the battery module to generate first sensing data of at least one of the plurality of battery cells, and a battery auxiliary management unit configured to generate second sensing data of at least one of the plurality of battery cells. The battery monitoring IC may receive the second sensing data from the battery auxiliary management unit, perform communication conversion on the second sensing data to generate converted second sensing data by converting a type of the second sensing data, and externally transmit the converted second sensing data.

For example, the battery management apparatus may further include a printed circuit board disposed in the battery module. The battery monitoring IC and the battery auxiliary management unit may be disposed on the printed circuit board. The battery monitoring IC may receive the second sensing data from the battery auxiliary management unit through the printed circuit board. The battery monitoring IC may externally transmit the first sensing data and the second sensing data to an external device spaced apart from the printed circuit board.

For example, the first sensing data may include at least one of temperature data, voltage data, or current data of at least one of the plurality of battery cells. The second sensing data may include at least one of pressure sensing data, gas sensing data, or aerosol sensing data of at least one of the plurality of battery cells.

For example, the battery monitoring IC may receive additional first sensing data and additional second sensing data from an additional battery monitoring IC disposed in an additional battery module. The battery monitoring IC may transmit the additional first sensing data and the additional second sensing data to an external device, other than the additional battery module.

### BRIEF DESCRIPTION OF DRAWINGS

Certain aspects, features, and advantages of the disclosed technology are illustrated by the following detailed description with reference to the accompanying drawings.
FIG. 1 is a diagram illustrating an electric vehicle including a battery of a battery management apparatus based on an example embodiment of the disclosed technology.
FIG. 2 is an exploded perspective view of a battery of a battery management apparatus based on an example embodiment of the disclosed technology.
FIG. 3 is an exploded perspective view of a battery module of a battery management apparatus based on an example embodiment of the disclosed technology.
FIG. 4 is a diagram illustrating a portion of a battery module of a battery management apparatus based on an example embodiment of the disclosed technology.
FIGS. 5 to 11 are diagrams illustrating a battery management apparatus and a battery module based on an example embodiment of the disclosed technology.
FIGS. 12A and 12B are diagrams illustrating, over time, how a single master controller controls a plurality of battery modules using a daisy chain method, in a battery management apparatus and a battery module based on an example embodiment of the disclosed technology.
FIGS. 13A and 13B are diagrams illustrating, over time, how sensing data from a plurality of battery modules is transmitted to a single master controller using a daisy chain method, in a battery management apparatus and a battery module based on an example embodiment of the disclosed technology.

### DETAILED DESCRIPTION

Various example embodiments will now be described with reference to the accompanying drawings.

The disclosed technology can be implemented in some embodiments to provide a battery management apparatus.

Sensing data from a battery can help ensure battery security, and a battery management system (BMS) may collect the sensing data. As the amount and types of sensing data increase, the reliability of battery safety monitoring may be improved. However, the increase in the amount and types of sensing data can reduce the efficiency and stability of the battery management system in collecting and processing the sensing data. The disclosed technology can be implemented in some embodiments to address these issues.

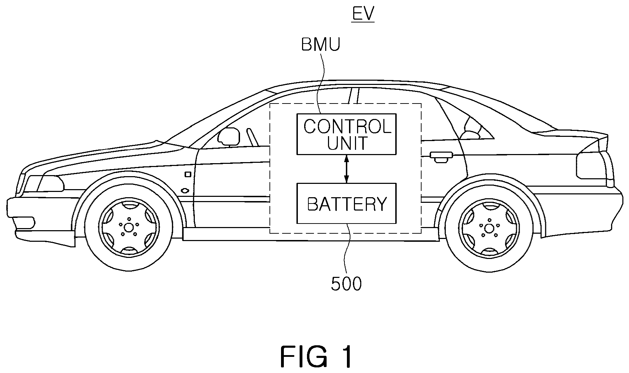

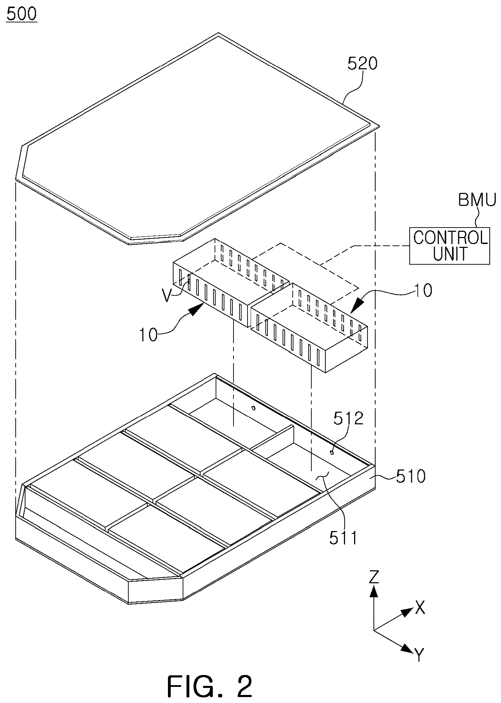

FIG. 1 is a diagram illustrating an electric vehicle EV including a battery 500 of a battery management apparatus based on an example embodiment of the disclosed technology. FIG. 2 is an exploded perspective view of a battery 500 of a battery management apparatus based on an example embodiment of the disclosed technology, and may be the battery 500 in FIG. 1, but the disclosed technology is not limited thereto.

Referring to FIG. 1, an electric vehicle EV may include a battery 500 and a battery management unit BMU that are in communication with each other. The battery management unit BMU is a controller part of a battery management apparatus SYS1 that operates to monitor the conditions and operations of the battery modules (and battery cells) in the battery 500 (e.g., a voltage, a current, a temperature and/or other parameters of each battery module within the battery 500) and adjust and control the operations of the battery modules in the battery 500 to improve the overall operations and performance of the battery 500. For example, the battery management unit BMU may include a master controller controlling the battery 500. In some embodiments, the battery management unit BMU may further include an interface IC mediating communications between the master controller and the battery 500. For example, the battery management unit BMU may interface with sensing circuitry or sensing mechanisms within the battery management apparatus SYS1 (such as a voltage sensor, a current sensor or a temperature sensor disposed in a battery module of the battery 500) to monitor a state of charge and a remaining lifespan of the battery 500 and output the same to a driver of the electric vehicle EV through a display or others.

Referring to FIG. 2, the battery 500 may include one or more battery modules 10, and may be implemented as a battery pack. Each battery module 10 may include one or more battery cells. The battery 500 may include a pack housing 510 having an accommodation space 511, one or more battery modules 10 disposed in the pack housing 510, and a pack cover member 520 disposed on an upper portion of the pack housing 510.

In the accommodation space 511, a plurality of battery modules 10 may be isolated from each other by a partition member. The partition member may serve to block the propagation or transfer of flames or fire between the battery modules 10.

The pack housing 510 may include at least one pack venting hole 512. The pack venting hole 512 may serve to discharge venting gas discharged from a venting hole V of the battery module 10 to the outside of the battery 500.

The pack cover member 520 may serve to protect the battery module 10 under normal conditions, and in the event of a fire, it may prevent flames generated in the battery 500 from spreading to the outside of the battery 500. This may contribute to ensuring user safety in the electric vehicle EV in which the battery 500 is mounted.

The battery management unit BMU may communicate with one or more battery modules 10 in a wired manner or wireless manner in various implementations, may not be directly disposed in the battery 500 in some implementations, and may be disposed on the outside of the battery 500 (e.g., a computing system in an electric vehicle, a computing system of an electronic device, or other modules outside the battery 500).

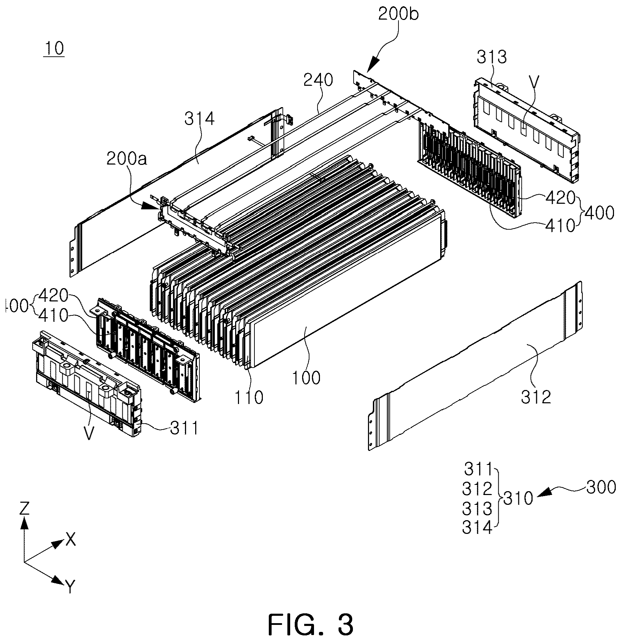

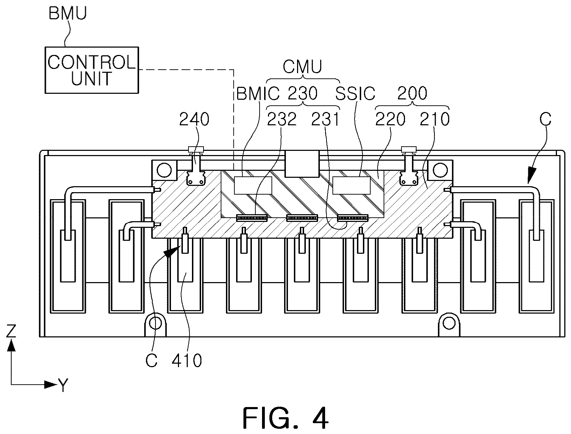

FIG. 3 is an exploded perspective view illustrating an example of the battery module 10 of the battery management apparatus based on an embodiment of the disclosed technology, and may be one or more battery modules 10 included in the battery 500 in FIG. 2, but the disclosed technology is not limited thereto. FIG. 4 is a diagram illustrating an example of an implementation of a portion of the battery module 10 in FIG. 3.

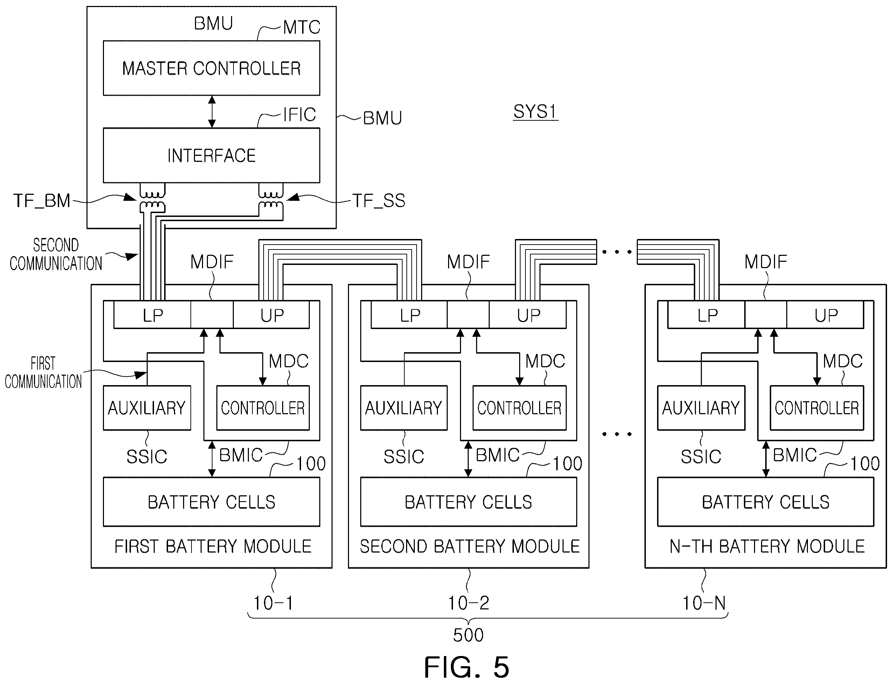

Referring to FIGS. 3 and 4, the battery module 10 may include a plurality of battery cells 100 stacked in a Y-axis direction (or a thickness direction of the battery cell), and may further include a printed circuit board 200, a casing unit 300, and/or a busbar unit 400. The printed circuit board 200 may be included in a battery management apparatus SYS1 in FIG. 5.

Each of the plurality of battery cells 100 may include a case for containing battery cell components, a cathode, and an anode, and an electrolyte and a separator may be disposed between the cathode and the anode in the case. The battery cells 100 may be implemented in various battery cell designs. For example, each battery cell 100 may be implemented as a lithium-ion cell so that the battery is a lithium-ion battery. In this lithium-ion cell design example, in a charging operation, lithium ions emitted from the cathode may be concentrated on the anode through the separator, and, in a discharging operation, lithium ions emitted from the anode may pass through the separator and may be concentrated on the cathode.

Each of the plurality of battery cells 100 may include a plurality of electrode leads 110 extending in a +X and -X directions. The busbar unit 400 may include one or more electrical conductive members to provide the electrical connections and may include, for example, a busbar member 410 and a busbar frame 420. The busbar unit 400 may connect the electrode leads 110 extending in the +X direction from the plurality of battery cells 100 to each other. The busbar unit 400 may connect the electrode leads 110 extending in the -X direction from the plurality of battery cells 100 to each other.

The casing unit 300 may include a plurality of plate members 310 surrounding the battery cell 100, and may accommodate the plurality of battery cells 100, the printed circuit board 200, and the busbar unit 400. The plate member 310 may include a first plate member 311, a second plate member 312, a third plate member 313, and a fourth plate member 314, surrounding the exterior of the battery cell 100. The first plate member 311, the second plate member 312, the third plate member 313, and the fourth plate member 314 may include a material having at least one physical property among heat resistance, fire resistance, and elasticity.

The first plate member 311 may face the electrode lead 110 on one side of the battery cell 100, and the third plate member 313 may face the electrode lead 110 on the other side of the battery cell 100. Each of the electrode lead 110 on the one side of the battery cell 100 and the electrode lead 110 on the other side of the battery cell 100 may be connected to the busbar member 410.

Each of the first plate member 311 and the third plate member 313 may face the busbar frame 420. A plurality of busbar members 410 may be fixed to the busbar frame 420, and the busbar frame 420 may include a busbar venting hole (not illustrated) for discharging venting gas generated in the battery cell 100.

Each of the first plate member 311 and the third plate member 313 may include a venting hole V that faces the busbar member 410. Accordingly, venting gas generated in the battery cell 100 may pass through the busbar venting hole (not illustrated) and the venting hole V, allowing it to be discharged to the outside of the battery module 10.

In addition to the busbar member 410, an insulating cover, an insulating sheet, and a heat-resistant sheet may be provided between the casing unit 300 and the battery cell 100, and the insulating cover, the insulating sheet, and the heat-resistant sheet may serve to insulate the casing unit 300 from the battery cell 100, to suppress the occurrence of fire in the battery module 10, and to suppress the propagation of flames from the battery module 10.

The printed circuit board 200 may include a front portion 200a and a rear portion 200b of the printed circuit board, and may include a connection member 240 connecting the front portion 200a and the rear portion 200b to each other. For example, the connection member 240 may be implemented as a flexible printed circuit board (FPCB), FFC, ribbon, cable, wire, or others, and thus may be more flexible than the front portion 200a and the rear portion 200b of the printed circuit board.

The printed circuit board 200 in FIG. 4 may correspond to the front portion 200a or the rear portion 200b. For example, the printed circuit board 200 may include a first substrate 210 connected to the battery cell 100, and a second substrate 220 that is attachable to or detachable from the first substrate 210. The connection unit 230 may be connected between the first substrate 210 and the second substrate 220 such that the first substrate 210 and the second substrate 220 may be attached to each other or detached from each other. The connection unit 230 may include a plurality of electrical connectors such as 231 and 232 as marked in the example in FIG. 4. Depending on the design, the first substrate 210 and the second substrate 220 may be implemented as a single printed circuit board.

The electrode leads 110 of the plurality of battery cells 100 and the printed circuit board 200 may be connected to each other by a connection portion C. The connection portion C may include a wire, and may be connected and fixed to the electrode leads 110 and the printed circuit board 200 by welding. The electrode lead 110 may also be connected to the busbar member 410 by welding.

FIG. 5 is a diagram illustrating an example of a battery management apparatus SYS1 that includes a battery management unit BMU and other battery management components that are implemented in a plurality of battery modules 10-1, 10-2, and 10-N based on an embodiment of the disclosed technology. The plurality of battery modules 10-1, 10-2, ..., and 10-N may be the battery modules 10 in FIGS. 3 and 4, but the disclosed technology is not limited thereto.

Referring to FIGS. 3 to 5, the battery management apparatus SYS1 based on an embodiment of the disclosed technology may include the battery management unit BMU that is separate from the battery modules 10-1, 10-2, ..., and 10-N, and other battery management components that are in communications with the BMU. In the specific example in FIG. 5, for example, other battery management components of the battery management apparatus SYS1 may include a battery monitoring integrated circuit (IC) BMIC to measure or sense various parameters of the battery module 10 and a battery auxiliary management unit SSIC to work together for monitoring status of the battery module 10 by collecting data on each battery module of battery modules 10-1, 10-2, ..., and 10-N and sending the collected data to the battery management unit BMU. For example, a cell monitoring unit CMU may include the battery monitoring IC BMIC and the battery auxiliary management unit SSIC, and may further include the printed circuit board 200. A plurality of cell monitoring units CMU may be disposed in the plurality of battery modules 10, respectively, and each of the plurality of cell monitoring units CMU may include the battery monitoring IC BMIC and the battery auxiliary management unit SSIC, and may further include the printed circuit board 200.

The battery monitoring IC BMIC, which is part of the battery management apparatus SYS1, may be disposed in the battery module 10 to generate first sensing data of the battery module 10. The first sensing data may include at least one of temperature data, voltage data, current data, and voltage data of at least one of the plurality of battery cells of the battery module 10. For example, the battery monitoring IC BMIC may be implemented as a semiconductor integrated circuit and/or a semiconductor chip, may be disposed (e.g., mounted) on the printed circuit board 200, may be electrically connected to the electrode lead 110 through a wiring of the printed circuit board 200 and the connection portion C, and may include a circuit for measuring a voltage of the electrode lead 110 and/or a circuit for measuring a current of the electrode lead 110. For example, the battery monitoring IC BMIC may be electrically connected to a temperature sensor (not illustrated) through the wiring of the printed circuit board 200. For example, the temperature sensor may be a thermistor, and the battery monitoring IC BMIC may include a circuit for measuring a voltage or a current of the thermistor.

The battery auxiliary management unit SSIC, which is also part of the battery management apparatus SYS1, may be disposed in the battery module 10 to generate second sensing data of the battery module 10. The second sensing data may include at least one of pressure sensing data, gas sensing data, and aerosol sensing data. For example, the battery auxiliary management unit SSIC may be implemented as a semiconductor integrated circuit, and may be disposed (e.g., mounted) on the printed circuit board 200. For example, when the battery module 10 approaches the end of a lifespan thereof, the battery module 10 may swell, and the battery auxiliary management unit SSIC may measure an increase in pressure due to the swelling of the battery module 10. For example, when the battery module 10 approaches the end of a lifespan thereof, the battery module 10 may generate gas or aerosol through a fine gap, and the battery auxiliary management unit SSIC may measure the generation of the gas or aerosol.

Referring to FIG. 5, the battery management unit BMU as part of the battery management apparatus SYS1 may include a master controller MTC and an interface IC IFIC. The battery management unit BMU may be the battery management unit BMU illustrated in FIGS. 1, 2, and 4, but the disclosed technology is not limited thereto.

The master controller MTC may communicate with the battery monitoring IC BMIC in a wired manner or wireless manner. For example, the master controller MTC may control an operation of the battery monitoring IC BMIC (e.g., control whether the battery monitoring IC BMIC is operated, control a timing for collecting sensing data from the battery monitoring IC BMIC, emergency cut-off control of the plurality of battery modules 10-1, 10-2, and 10-N) by transmitting a control command to the battery monitoring IC BMIC.

The interface IC IFIC may perform a communication conversion operation for communication between the battery monitoring IC BMIC and the master controller MTC. The battery management unit BMU may be disposed on the outside (e.g., a computing system in an electric vehicle, a computing system of an electronic device, or others) of the battery 500, may be implemented as a computing system (e.g., including a processor, a memory, an input/output device, a communication device, and a main board), and the master controller MTC may be a portion of the computing system, and may be implemented as a semiconductor integrated circuit mounted on the main board.

The battery management unit BMU may be disposed on the outside of the battery 500, and thus communication between the master controller MTC and the battery monitoring IC BMIC may require stability (e.g., low noise, high signal-noise ratio SNR). The interface IC IFIC may be included in the battery management unit BMU, and thus communication between the interface IC IFIC and the battery monitoring IC BMIC may require stability higher than that of communication between the interface IC IFIC and the master controller MTC. A plurality of communication schemes may have different types of stability. For example, the interface IC IFIC may perform a communication conversion operation to use a communication scheme having higher stability for communication with the battery monitoring IC BMIC. Accordingly, communication between the battery management unit BMU and the battery monitoring IC BMIC may exhibit further improved stability. In some implementations, the communication conversion operation may include a communication protocol conversion that converts communication protocols or signal types to facilitate communication between two different components.

For example, an interface IC IFIC may be implemented as a semiconductor integrated circuit and/or a semiconductor chip, may communicate with the master controller MTC according to a serial peripheral interface (SPI) method (or SPI protocol) or an inter-integrated circuit (I2C) method (or I2C protocol), and may communicate with the battery monitoring IC BMIC using a universal synchronous receiver/transmitter (UART) method (or UART protocol) or the SPI method (or SPI protocol). For example, the interface IC IFIC may perform at least one of first communication conversion between the SPI method and the UART method, second communication conversion between the I2C method and the SPI method, and third communication conversion between the I2C method and the UART method.

A communication conversion operation of the interface IC IFIC may include conversion between a single-ended signal and a differential signal. For example, the interface IC IFIC may receive the single-ended signal from the master controller MTC, convert the single-ended signal into a differential signal, transmit the differential signal to the battery monitoring IC BMIC, receive a differential signal from the battery monitoring IC BMIC, convert the differential signal into a single-ended signal, and transmit the single-ended signal to the master controller MTC. The differential signal may be advantageous to be used in a communication scheme having high stability, compared to the single-ended signal.

For example, the battery monitoring IC BMIC may include an interface IC MDIF and a controller MDC, and may be implemented as a chipset. The controller MDC may generate first sensing data and transmit the first sensing data to the interface IC MDIF. The interface IC MDIF may generate a communication signal having the first sensing data, and may perform a communication conversion operation. The communication conversion operation may be substantially the same as the communication conversion operation of the interface IC IFIC. Accordingly, the battery monitoring IC BMIC may stably transmit the first sensing data to the interface IC IFIC, and the master controller MTC may receive the first sensing data through the interface IC IFIC.

The master controller MTC may collect second sensing data from the battery auxiliary management unit SSIC, thereby further increasing the reliability of securing safety of the battery 500 using the second sensing data. The battery monitoring IC BMIC may perform a communication conversion operation to mediate communication between the battery auxiliary management unit SSIC and the interface IC IFIC. Accordingly, even when a communication conversion mechanism for communication between the battery auxiliary management unit SSIC and the interface IC IFIC is not included, the interface IC IFIC or the master controller MTC may stably perform communication with the battery auxiliary management unit SSIC.

The battery monitoring IC BMIC may receive second sensing data from the battery auxiliary management unit SSIC, perform communication conversion on the second sensing data, and transmit the second sensing data on which communication conversion is performed to the interface IC IFIC or the master controller MTC. Accordingly, even when a communication conversion mechanism for communication between the battery auxiliary management unit SSIC and the interface IC IFIC is not included, the interface IC IFIC or the master controller MTC may stably receive the second sensing data.

Accordingly, even when the number and types of sensing data items increase due to the addition of the battery auxiliary management unit SSIC, the cost and/or complexity of implementing a structure in which the master controller MTC collects sensing data may only slightly increase, and stability of collecting sensing data may also be ensured.

For example, the battery monitoring IC BMIC may receive second sensing data from the battery auxiliary management unit SSIC through the printed circuit board 200, and may communicate with the battery auxiliary management unit SSIC using the SPI method or the I2C method. The interface IC MDIF of the battery monitoring IC BMIC may perform at least one of first communication conversion between the SPI method and the UART method, second communication conversion between the I2C method and the SPI method, and third communication conversion between the I2C method and the UART method. The interface IC IFIC may receive the second sensing data transmitted from the battery monitoring IC BMIC, perform communication conversion on the received second sensing data, and transmit the second sensing data on which communication conversion is performed to the master controller MTC.

Referring to FIG. 5, the battery management apparatus SYS1 and the battery modules 10-1, 10-2, and 10-N based on an embodiment of the disclosed technology may include a first insulating communication port TF_BM and a second insulating communication port TF_SS. For example, each of the first insulating communication port TF_BM and the second insulating communication port TF_SS may be implemented as a transformer or an isolator.

A signal transmitted from the master controller MTC may pass through the first insulating communication port TF_BM, a signal transmitted from the battery monitoring IC BMIC may pass through the first insulating communication port TF_BM, and a differential signal having the first sensing data generated by the battery monitoring IC BMIC may pass through the first insulating communication port TF_BM. The second sensing data transmitted from the battery monitoring IC BMIC may pass through the second insulating communication port TF_SS, and a differential signal having the second sensing data may pass through the second insulating communication port TF_SS.

The cost and complexity of adding the second insulating communication port TF_SS may be significantly lower than those of adding a communication conversion mechanism for communication between the battery auxiliary management unit SSIC and the interface IC IFIC. The first insulating communication port TF_BM and the second insulating communication port TF_SS may include a signal transmission point where a wire between the interface IC IFIC and the battery monitoring IC BMIC is cut off and a signal passes via a magnetic field, thereby improving insulation performance. In this way, communication stability between the interface IC IFIC and the battery monitoring IC BMIC may be efficiently improved.

Referring to FIG. 5, the battery management apparatus SYS1 based on an embodiment of the disclosed technology may include a plurality of battery modules 10-1, 10-2, and 10-N, and each of the battery modules 10-1, 10-2, and 10-N may include a plurality of battery cells 100 stacked on each other (see FIG. 3) . The battery management apparatus SYS1 based on an embodiment of the disclosed technology may include a plurality of battery monitoring ICs BMIC respectively disposed in the plurality of battery modules 10-1, 10-2, and 10-N, and may include a plurality of battery auxiliary management units SSIC respectively disposed in the plurality of battery modules 10-1, 10-2, and 10-N.

The plurality of battery monitoring ICs BMIC may transmit sensing data items between the plurality of battery monitoring ICs BMIC to adjacent battery monitoring ICs through a daisy chain method. In some implementations, the daisy chain method may include a method of connecting multiple devices in a series, where an output of one device is connected to an input of the next device, allowing a signal or power to flow through them in a chain-like fashion. For example, a battery monitoring IC BMIC of the first battery module 10-1 may receive additional first sensing data and additional second sensing data from an additional battery monitoring IC BMIC disposed in the second battery module 10-2, an additional battery module, and may transmit additional first sensing data and additional second sensing data to an external device (e.g., the interface IC IFIC or the master controller MTC) . The sensing data items may include second sensing data generated by each of the plurality of battery auxiliary management units SSIC and/or first sensing data generated by each of the plurality of battery monitoring ICs BMIC. For example, the plurality of battery monitoring ICs BMIC may communicate with the adjacent battery monitoring ICs BMIC through a plurality of communication ports LP and UP of each of the interface ICs MDIF.

According to the daisy chain method, even when only one of the plurality of battery monitoring ICs BMIC communicates with the battery management unit BMU, the other battery monitoring ICs, among the plurality of battery monitoring ICs BMIC, may communicate with the battery management unit BMU through one of the plurality of battery monitoring ICs BMIC. Accordingly, the plurality of battery monitoring ICs BMIC of the battery management unit BMU may be efficiently controlled, and the sensing data items may be efficiently received from the plurality of battery monitoring ICs BMIC.

For example, one of the interface ICs MDIF, included in each of the plurality of battery monitoring ICs BMIC, may perform communication conversion between the daisy chain method and the UART method or communication conversion between the daisy chain and the SPI method. One of the plurality of battery monitoring ICs BMIC may transmit a plurality of second sensing data items to the interface IC IFIC or the master controller MTC.

Communication conversion may also be performed on a plurality of second sensing data items, transmitted by the plurality of battery auxiliary management units SSIC to the plurality of battery monitoring ICs BMIC, by one of the interface ICs MDIF, and the converted data may be transmitted using the daisy chain method. Accordingly, even when a mechanism for the daisy chain method of the plurality of battery auxiliary management units SSIC is not included, the interface IC IFIC or the master controller MTC may efficiently receive the plurality of second sensing data items of the plurality of battery auxiliary management units SSIC through the daisy chain method. Using the daisy chain method, one of the plurality of battery monitoring ICs BMIC may perform communication conversion on the plurality of pieces of second sensing data using the UART method or the SPI method, and transmit the pieces of second sensing data on which communication conversion is performed to the interface IC IFIC or the master controller MTC.

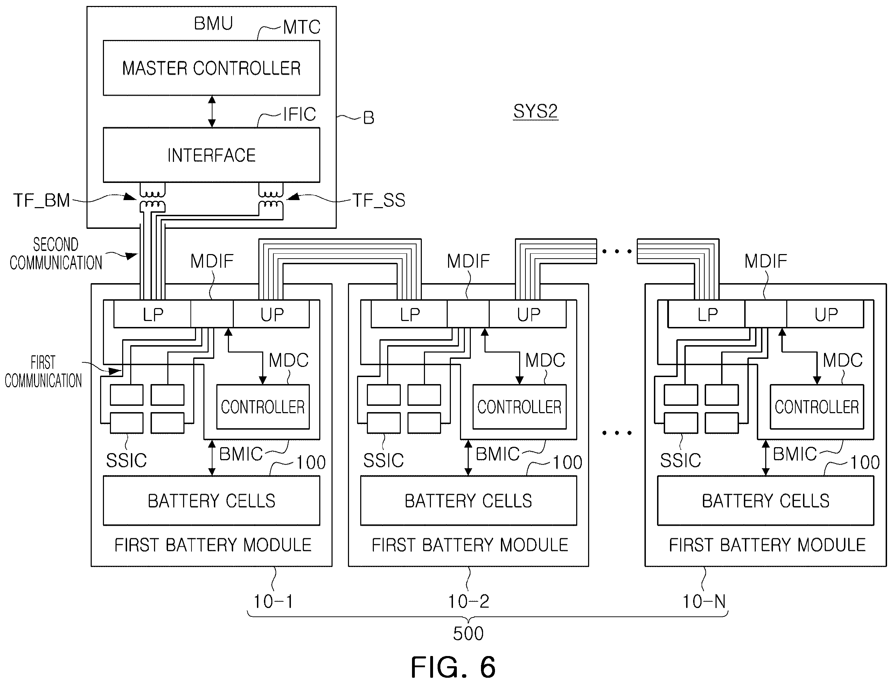

FIGS. 6 to 11 are diagrams illustrating battery management apparatuses SYS2, SYS3, SYS4, SYS5, SYS6, and SYS7 and battery modules 10-1, 10-2, and 10-N based on an embodiment of the disclosed technology. Hereinafter, descriptions, overlapping those of the battery management apparatus SYS1 in FIG. 5, will be omitted.

Referring to FIG. 6, each of a plurality of battery modules 10-1, 10-2, and 10-N may include a plurality of battery auxiliary management units SSIC. For example, a plurality of battery auxiliary management units SSIC, included in one battery module 10-N, may be respectively configured as battery auxiliary management units other than each other, such as a pressure battery auxiliary management unit, a gas battery auxiliary management unit, and an aerosol battery auxiliary management unit, or may be distributed and disposed in different physical positions of the one battery module 10-N.

As illustrated in FIG. 6, in a battery management apparatus SYS2 based on an embodiment of the disclosed technology, even when the number of the plurality of battery auxiliary management units SSICs is significantly increased and the types of the plurality of battery auxiliary management units SSICs are significantly diversified, the cost and/or complexity of implementing a structure in which a master controller (or external device) collects sensing data may increase only slightly, and stability of collecting sensing data may also be ensured.

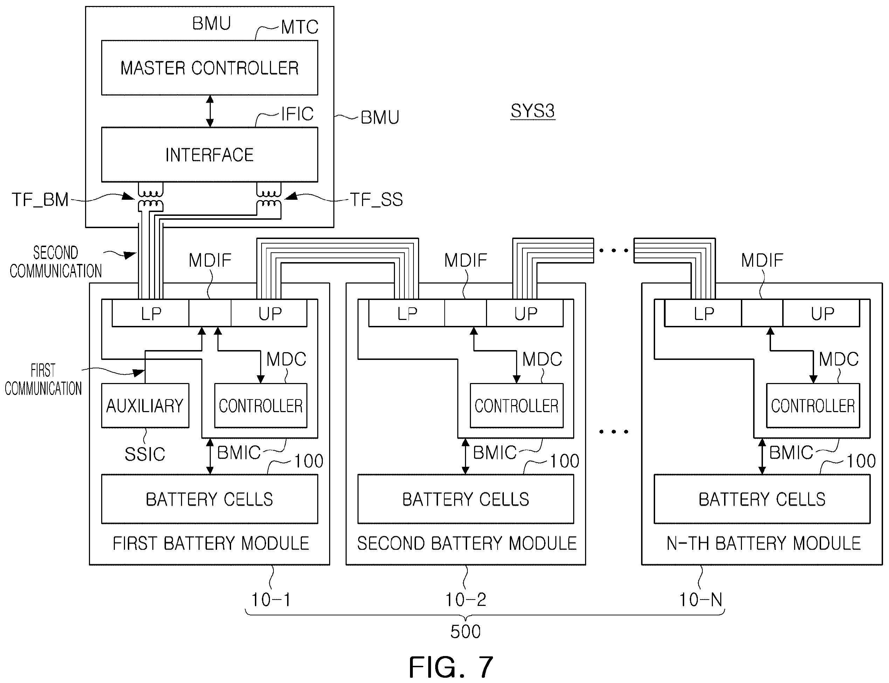

Referring to FIG. 7, a battery auxiliary management unit SSIC of a battery management apparatus SYS3 based on an embodiment of the disclosed technology may be disposed in only one of the plurality of battery modules 10-1, 10-2, and 10-N. Here, second sensing data of the battery auxiliary management unit SSIC may not be transmitted using the daisy chain method. For example, the battery auxiliary management unit SSIC may generate second sensing data for a battery 500 rather than for a battery module.

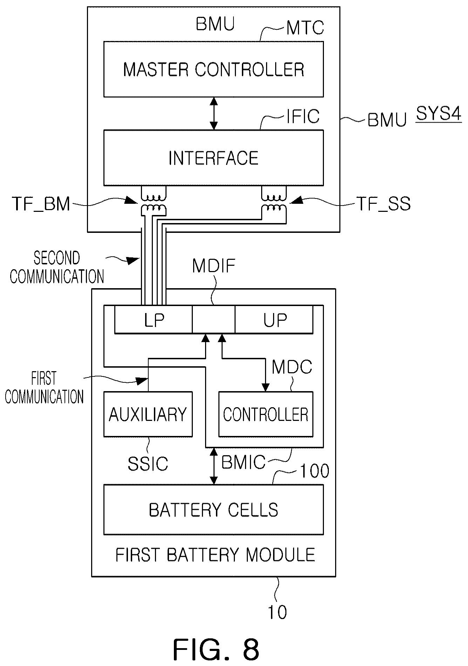

Referring to FIG. 8, a battery 500 of a battery management apparatus SYS4 based on an embodiment of the disclosed technology may include only one battery module 10. Here, a battery monitoring IC BMIC may not use the daisy chain method.

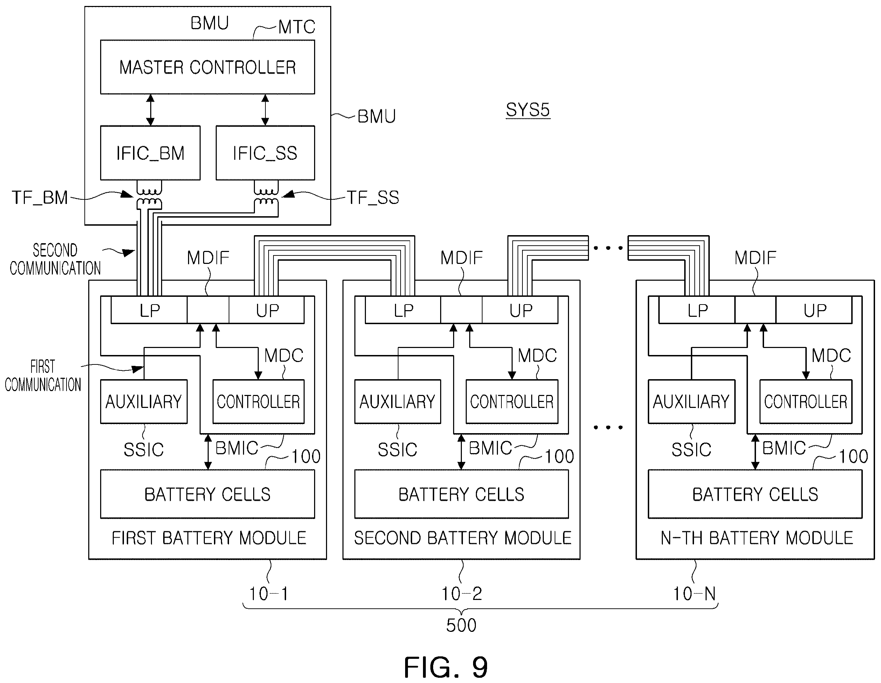

Referring to FIG. 9, a battery management apparatus SYS5 based on an embodiment of the disclosed technology may further include an auxiliary interface unit IFIC_SS performing a communication conversion operation for communication between a battery monitoring IC BMIC and a master controller MTC. The battery monitoring IC BMIC may transmit second sensing data on which communication conversion is performed to the master controller MTC through the auxiliary interface unit IFIC _SS. The interface IC IFIC_BM may be electrically connected to a first insulating communication port TF_BM, and the auxiliary interface unit IFIC_SS may be electrically connected to a second insulating communication port TF_SS. For example, the master controller MTC may transmit a control command to the interface IC IFIC_BM only without transmitting the control command to the auxiliary interface unit IFIC_SS, and the battery monitoring IC BMIC may transmit first sensing data to the interface IC IFIC_BM only without transmitting the first sensing data to the auxiliary interface unit IFIC _SS.

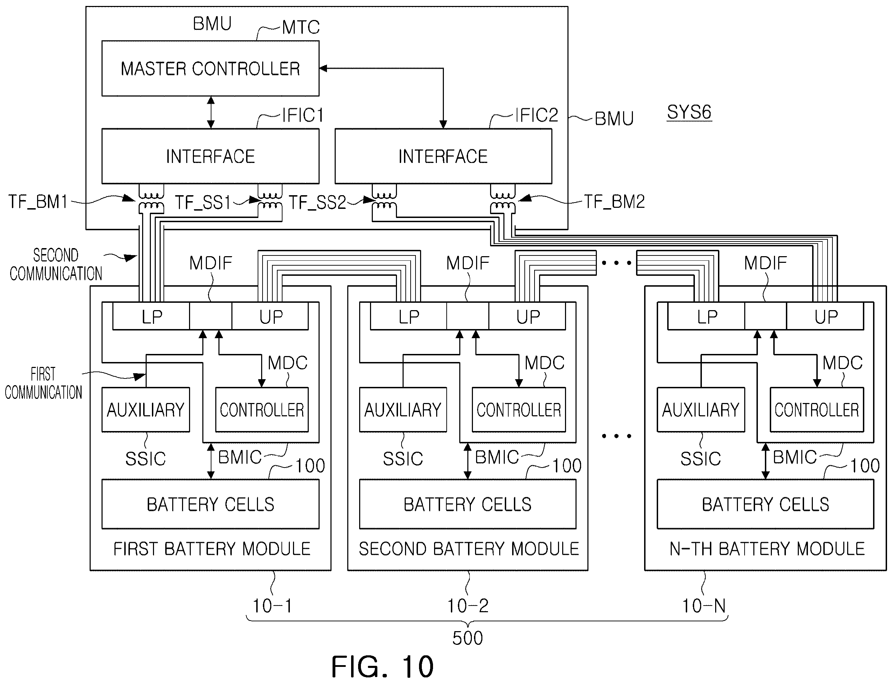

Referring to FIG. 10, a battery management apparatus SYS6 based on an embodiment of the disclosed technology may include a plurality of interface ICs IFIC1 and IFIC2. Each of the plurality of interface ICs IFIC1 and IFIC2 may perform a communication conversion operation, substantially the same as that of the interface ICs IFIC in FIG. 5. Each of the plurality of interface ICs IFIC1 and IFIC2 may communicate with a corresponding one of the plurality of battery monitoring ICs BMIC through first insulating communication ports TF_BM1 and TF_BM2 and second insulating communication ports TF_SS1 and TF_SS2.

According to the daisy chain method, the plurality of battery monitoring ICs BMIC may transmit sensing data items and a control command to both adjacent battery monitoring ICs (e.g., bidirectional transmission), As a result, the left half of the plurality of battery monitoring ICs BMIC may transmit sensing data items to the battery management unit BMU through a battery monitoring IC BMIC at the left end, and the right half of the plurality of battery monitoring ICs BMIC may transmit sensing data items to the battery management unit BMU through a battery monitoring IC BMIC at the right end.

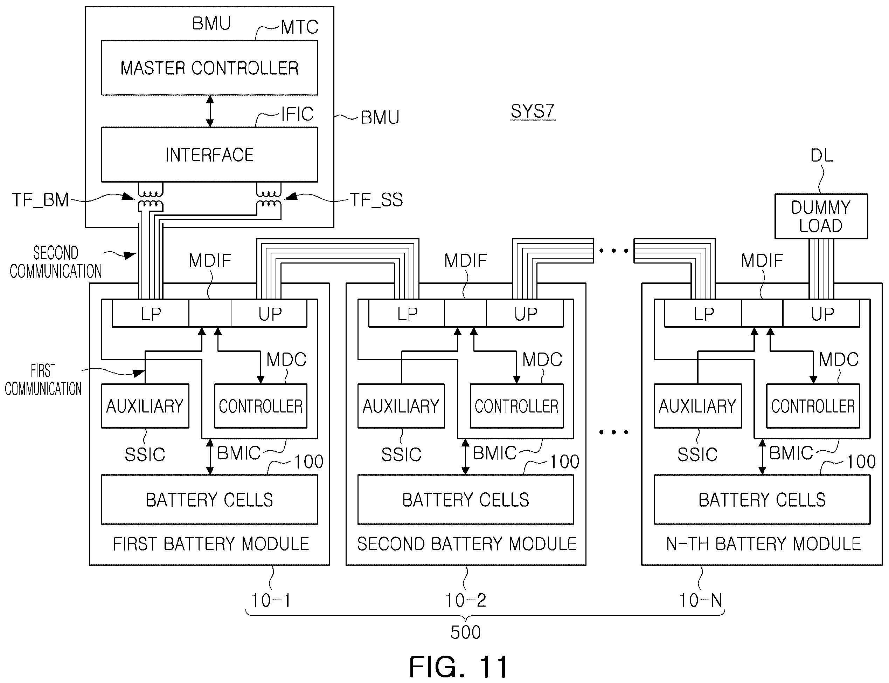

Referring to FIG. 11, a battery management apparatus SYS7 based on an embodiment of the disclosed technology may further include a dummy load DL electrically connected to the other one of the plurality of battery monitoring ICs BMIC. The dummy load DL may remove sensing data items and a control command received using the daisy chain method. For example, the dummy load DL may include impedance elements having an impedance set to remove the sensing data items and the control command, but the disclosed technology is not limited thereto.

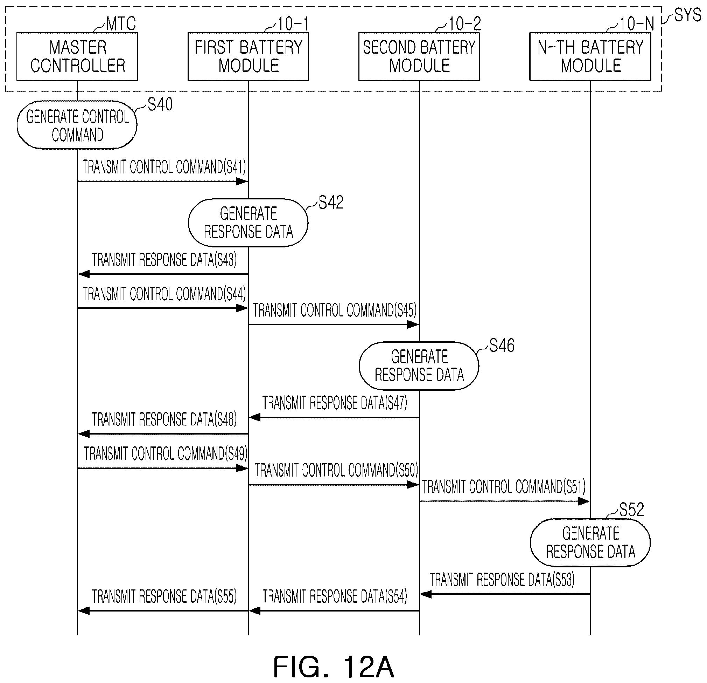

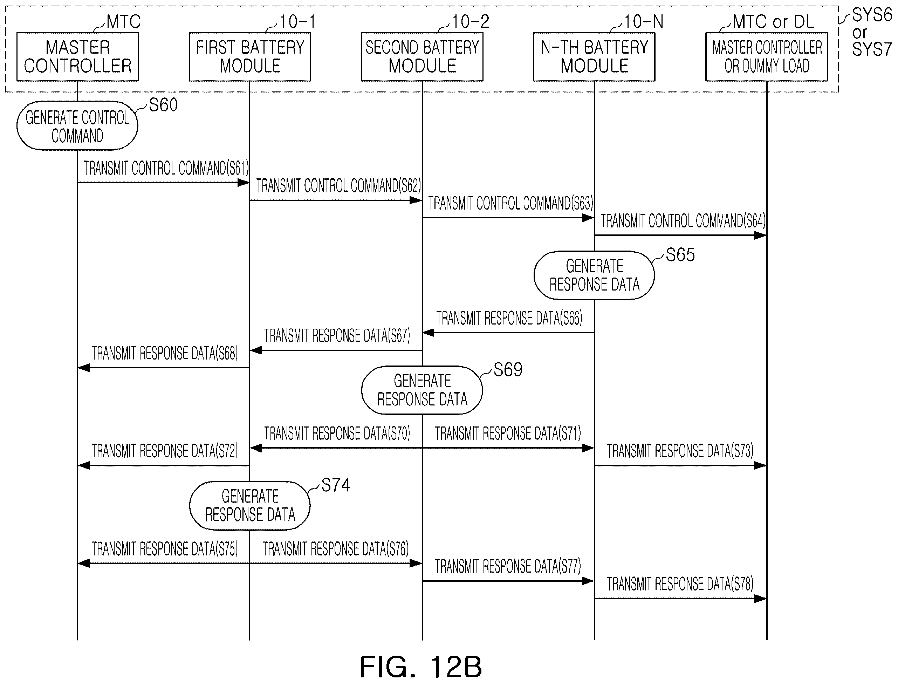

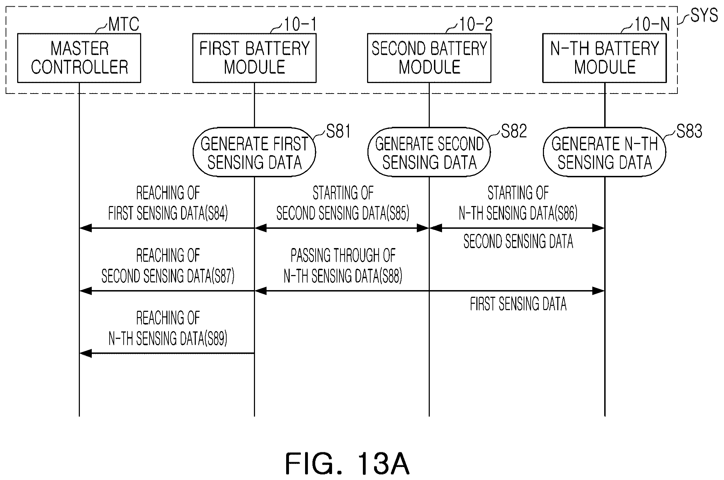

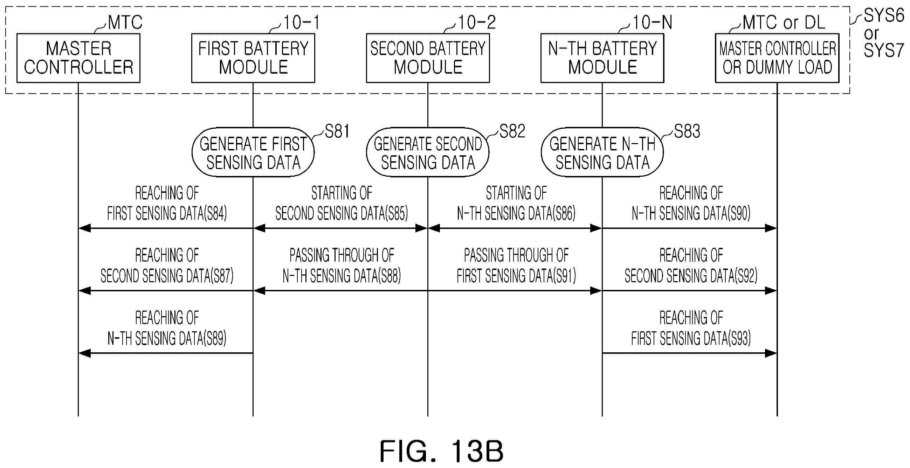

Referring to FIGS. 5 to 11, one of the plurality of battery monitoring ICs BMIC may receive a control command (see FIGS. 12A and 12B) from the master controller MTC through the interface IC IFIC, and the plurality of battery monitoring ICs BMIC may transmit the control command (see FIGS. 12A and 12B) to each other using the daisy chain method. In addition, the plurality of battery monitoring ICs BMIC may transmit sensing data (see FIGS. 13A and 13B) to each other using the daisy chain method, and one of the plurality of battery monitoring ICs BMIC may transmit sensing data (see FIGS. 13A and 13B) to the interface IC IFIC or the master controller MTC.

FIGS. 12A and 12B are diagrams illustrating, over time, how a single master controller controls a plurality of battery modules using a daisy chain method, in a battery management apparatus and a battery module based on an example embodiment of the disclosed technology.

Referring to FIG. 12A, a battery management apparatus SYS based on an embodiment of the disclosed technology may correspond to the battery management apparatuses SYS1, SYS2, SYS3, SYS4, and SYS5 in FIGS. 5 to 9, and a target to which a master controller MTC transmits a control command may be sequentially changed from a first battery module 10-1 to an N-th battery module 10-N, but the order of the target to which the control command is transmitted is not limited thereto.

Referring to FIG. 12B, a battery management apparatus SYS6 or SYS7 based on an embodiment of the disclosed technology may correspond to the battery management apparatuses SYS6 and SYS7 shown in FIGS. 10 and 11. In this configuration, the target to which the master controller MTC transmits a control command may be sequentially changed from the N-th battery module 10-N to the first battery module 10-1, but the order in which the control command is transmitted is not limited thereto.

The master controller MTC in FIG. 12A may generate a plurality of control commands for each of a plurality of battery modules 10-1, 10-2, and 10-N, and the master controller MTC in FIG. 12B may generate a single control command for the plurality of battery modules 10-1, 10-2, and 10-N. However, the number of control commands is not limited. Depending on the design, the master controller MTC in FIG. 12A may generate a single control command for the plurality of battery modules 10-1, 10-2, and 10-N, and the master controller MTC in FIG. 12B may also generate a plurality of control commands. For example, the target to which the master controller MTC transmits a control command may be identified or classified based on identification data such as address data or an ID included in a communication signal.

Referring to FIG. 12A, the master controller MTC may generate a control command for a first battery module 10-1 (S40) and transmit the control command to the first battery module 10-1 (S41). The first battery module 10-1 may generate response data for the control command (S42) and transmit the response data to the master controller MTC (S43).

Thereafter, the master controller MTC may generate a control command for a second battery module 10-2 and transmit the control command to the first battery module 10-1 (S44), and the first battery module 10-1 may transmit the control command to the second battery module 10-2 (S45). The second battery module 10-2 may generate response data for the control command (S46) and transmit the response data to the first battery module 10-1 (S47), and the first battery module 10-1 may transmit the response data to the master controller MTC (S48).

Thereafter, the master controller MTC may generate a control command for an N-th battery module 10-N and transmit the control command to the first battery module 10-1 (S49), the first battery module 10-1 may transmit the control command to the second battery module 10-2, and the second battery module 10-2 may transmit the control command to the N-th battery module 10-N (S51). The N-th battery module 10-N may generate response data for the control command (S42) and transmit the response data to the second battery module 10-2 (S53), the second battery module 10-2 may transmit the response data to the first battery module 10-1 (S54), and the first battery module 10-1 may transmit the response data to the master controller MTC (S55).

Referring to FIG. 12B, the master controller MTC may generate a control command for the N-th battery module 10-N (S60) and transmit the control command to the first battery module 10-1 (S61), the first battery module 10-1 may transmit the control command to the second battery module 10-2, the second battery module 10-2 may transmit the control command to the N-th battery module 10-N (S63), and the N-th battery module 10-N may transmit the control command to the master controller MTC or a dummy load DL (S64). The N-th battery module 10-N may generate response data for the control command (S65) and transmit the response data to the second battery module 10-2 (S66), the second battery module 10-2 may transmit the response data to the first battery module 10-1 (S67), and the first battery module 10-1 may transmit the response data to the master controller MTC (S68).

Thereafter, the second battery module 10-2 may generate response data for the previously received control command (S69), and may bidirectionally transmit the response data (S70 and S71) . The first battery module 10-1 and the N-th battery module 10-N may transmit the response data to the master controller MTC or the dummy load DL (S72 and S73).

Thereafter, the first battery module 10-1 may generate response data for the previously received control command (S74), and may bidirectionally transmit the response data (S75 and S76) . The second battery module 10-2 and the N-th battery module 10-N may sequentially transmit the response data to the master controller MTC or the dummy load DL (S77 and S78).

FIGS. 13A and 13B are diagrams illustrating, over time, how sensing data from a plurality of battery modules is transmitted to a single master controller using a daisy chain method, in a battery management apparatus and a battery module based on an example embodiment of the disclosed technology.

Referring to FIG. 13A, a battery management apparatus SYS based on an embodiment of the disclosed technology may correspond to the battery management apparatuses SYS1, SYS2, SYS3, SYS4, and SYS5 in FIGS. 5 to 9. Referring to FIG. 13B, a battery management apparatus SYS6 or SYS7 based on an embodiment of the disclosed technology may correspond to the battery management apparatuses SYS6 and SYS7 in FIGS. 10 and 11. Referring to FIGS. 13A and 13B, a plurality of battery modules 10-1, 10-2, and 10-N may generate a plurality of sensing data items, but the number and points in time of the plurality of sensing data items are not limited. The plurality of sensing data items may correspond to the second sensing data and/or the first sensing data described above.

Referring to FIG. 13A, a plurality of battery modules 10-1, 10-2, and 10-N may generate a plurality of sensing data items (e.g., first sensing data, second sensing data, and N-th sensing data) (S81, S82, and S83). The first sensing data of a first battery module 10-1 may reach a master controller MTC (S84), the second sensing data may start from a second battery module 10-2 and be bidirectionally transmitted (S85), and the N-th sensing data may start from an N-th battery module 10-N (S86).

Thereafter, the second sensing data may reach the master controller MTC (S87), and the N-th sensing data may pass through the second battery module 10-2 (S88). Thereafter, the N-th sensing data may reach the master controller MTC (S89).

Referring to FIG. 13B, the N-th sensing data may be bidirectionally transmitted to reach the master controller MTC or a dummy load DL (S90). Thereafter, the first sensing data may pass through the second battery module 10-2 (S91), and the second sensing data may reach the master controller MTC or the dummy load DL (S92). Thereafter, the first sensing data may reach the master controller MTC or the dummy load DL (S93).

In example embodiments of the disclosed technology, a battery management apparatus may exhibit improved efficiency and/or stability of collecting sensing data on a battery module.

For example, even when the number and types of sensing data items increase due to the addition of a battery auxiliary management unit, the cost and/or complexity of implementing a structure in which a master controller (or external device) collects sensing data may increase only slightly, while maintaining the stability of collecting sensing data.

The disclosed technology can be implemented in the field of secondary batteries or rechargeable batteries that widely used in electric vehicles, uninterruptible power supplies, battery storage power stations, and others including battery power storage for solar panels, wind power generators and other green tech power generators. Specifically, the disclosed technology can be implemented in some applications to provide secondary batteries that can improve the battery reliability and performance and, accordingly, to mitigate climate change. Secondary batteries based on the disclosed technology can be used to address various adverse effects such as air pollution and greenhouse emissions by powering electric vehicles (EVs) as alternatives to vehicles using fossil fuel based engines and by providing battery based energy storage systems (ESS) to store renewable energy such as solar power and wind power.

Only specific examples of implementations of certain embodiments are described. Variations, improvements and enhancements of the disclosed embodiments and other embodiments may be made based on the disclosure of this patent document.

## Claims

1. A battery management apparatus comprising:
a cell monitoring unit including a battery monitoring integrated circuit (IC) configured to generate first sensing data of a battery module; and
a battery management unit communicatively coupled to the cell monitoring unit and including: a master controller in communication with the battery monitoring IC; and an interface IC configured to perform a communication conversion operation for communication between the battery monitoring IC and the master controller,
wherein the cell monitoring unit further includes a battery auxiliary management unit disposed in the battery module, and
wherein the battery monitoring IC is further configured to perform a communication conversion operation to facilitate communication between the battery auxiliary management unit and the interface IC.

2. The battery management apparatus of claim 1, wherein:
the battery auxiliary management unit is configured to generate second sensing data of the battery module, and
the battery monitoring IC is configured to: receive the second sensing data from the battery auxiliary management unit; perform communication conversion on the second sensing data to generate converted second sensing data by converting a type of the second sensing data; and transmit the converted second sensing data to the interface IC.

3. The battery management apparatus of claim 2, wherein the interface IC is configured to: receive the second sensing data transmitted from the battery monitoring IC; perform communication conversion on the converted second sensing data to generate resulting second sensing data; and transmit the resulting second sensing data to the master controller.

4. The battery management apparatus of claim 2 or 3, further comprising:
an auxiliary interface unit configured to perform a communication conversion operation for communication between the battery monitoring IC and the master controller,
wherein the battery monitoring IC is configured to transmit the converted second sensing data to the master controller through the auxiliary interface unit.

5. The battery management apparatus of any one of claims 2 to 4, further comprising:
a first insulating communication port configured to enable transmission of signals from both the master controller and the battery monitoring IC; and
a second insulating communication port configured to enable transmission of the second sensing data from the battery monitoring IC.

6. The battery management apparatus of any one of claims 2 to 5, wherein the first sensing data includes at least one of temperature data, voltage data, current data, or voltage data of at least one of a plurality of battery cells of the battery module, and
the second sensing data includes at least one of pressure sensing data, gas sensing data, or aerosol sensing data of the battery module.

7. The battery management apparatus of any one of claims 1 to 6, wherein the interface IC is configured to: receive a single-ended signal from the master controller; convert the single-ended signal into a differential signal; and transmit the differential signal to the battery monitoring IC, and
wherein the interface IC is further configured to: receive a differential signal from the battery monitoring IC; convert the differential signal into a single-ended signal; and transmit the single-ended signal to the master controller.

8. The battery management apparatus of any one of claims 1 to 7, wherein the cell monitoring unit further includes a printed circuit board disposed in the battery module, and
each of the battery monitoring IC and the battery auxiliary management unit includes a semiconductor integrated circuit electrically connected to the printed circuit board.

9. A battery management apparatus comprising:
a plurality of battery monitoring integrated circuits (ICs) respectively disposed in a plurality of battery modules, each battery module including a plurality of battery cells stacked on each other;
a master controller communicatively coupled to the plurality of battery monitoring ICs to communicate with at least one of the plurality of battery monitoring ICs;
an interface IC configured to perform a communication conversion operation for communication between one of the plurality of battery monitoring ICs and the master controller; and
a plurality of battery auxiliary management units respectively disposed in the plurality of battery modules,
wherein one of the plurality of battery monitoring ICs is configured to perform a communication conversion operation to facilitate communication between at least one of the plurality of battery auxiliary management units and the interface IC.

10. The battery management apparatus of claim 9, wherein the plurality of battery monitoring ICs transmit second sensing data of the plurality of battery auxiliary management units between the plurality of battery monitoring ICs through a daisy chain method, and
one of the plurality of battery monitoring ICs transmits the second sensing data to the interface IC or the master controller.

11. The battery management apparatus of claim 10, wherein the plurality of battery monitoring ICs generate converted second sensing data by converting the second sensing data, transmitted using the daisy chain method, through a universal asynchronous receiver/transmitter (UART) protocol or a serial peripheral interface (SPI) protocol, and transmit the converted second sensing data to the interface IC or the master controller.

12. The battery management apparatus of any one of claims 9 to 11, wherein one of the plurality of battery monitoring ICs receives a control command from the master controller through the interface IC, and
the plurality of battery monitoring ICs transmit the control command to each other using the daisy chain method.

13. The battery management apparatus of any one of claims 9 to 12, wherein the plurality of battery monitoring ICs transmit first sensing data to each other using the daisy chain method, and
one of the plurality of battery monitoring ICs transmits first sensing data of the plurality of battery monitoring ICs to the interface IC or the master controller.

14. The battery management apparatus of any one of claims 9 to 13, wherein the interface IC is configured to: receive a single-ended signal from the master controller; convert the single-ended signal into a differential signal; and transmit the differential signal to one of the plurality of battery monitoring ICs, and
wherein the interface IC is further configured to: receive a differential signal from one of the plurality of battery monitoring ICs; convert the differential signal into a single-ended signal; and transmit the single-ended signal to the master controller.

15. The battery management apparatus of any one of claims 9 to 14, wherein each of the plurality of battery monitoring ICs includes a semiconductor integrated circuit, and
each of the plurality of battery auxiliary management units includes a semiconductor integrated circuit.
